# EUROPEAN PATENT APPLICATION

(11) **EP 4 517 847 A1**
(43) Date of publication of application: **05.03.2025**
(21) Application number: 22938848.3
(22) Date of filing: 25.04.2022
(51) Int. Cl.: H01L 33/56, H01L 25/075

(54) **STRIP-SHAPED LIGHT-EMITTING DIODE AND APPLICATION DEVICE THEREOF**

(71) Applicant: Excellence Optoelectronics Inc., Chunan Town, Miaoli County 35053 (TW)
(72) Inventor: CHANG, Chih-chiang, Taiwan 35053 (TW); CHEN, Yen-cheng, Taiwan 35053 (TW); HUANG, Wen-hsing, Taiwan 35053 (TW); TSAI, Tzeng-guang, Taiwan 35053 (TW); HUANG, Kuo-hsin, Taiwan 35053 (TW)
(74) Representative: Viering, Jentschura & Partner mbB Patent- und Rechtsanwälte
(86) International application number: PCT/CN2022/088909
(87) International publication number: WO 2023/205989

(57) **Abstract**

A strip-shaped light-emitting diode (LED) (U) and an application device (Z) are provided. The strip LED (U) includes a substrate (1), a plurality of LED chips (3a, 3b, 3c, 3d, 3e, 3f), a plurality of electrical connection wires (2) connected to electrodes of the LED chips (3a, 3b, 3c, 3d, 3e, 3f), and a packaging colloid (4). The plurality of LED chips (3a, 3b, 3c, 3d, 3e, 3f) are linearly arranged, covered by the packaging colloid (4), and the packaging colloid (4) has a horizontal fine trench (5) between two specified adjacent LED chips (3a, 3b, 3c, 3d, 3e, 3f). Reliability of resistance to cold and hot temperature cycles or cold and hot shocks can be improved.

## Description

### FIELD OF THE DISCLOSURE

The present disclosure relates to a strip light-emitting diode (LED) and an application apparatus thereof, and in particular, to a strip LED and a strip LED light-emitting apparatus having a horizontal fine trench in a packaging colloid, which can improve reliability of a linear LED against cold and hot temperature cycles or cold and hot shocks.

### BACKGROUND OF THE DISCLOSURE

An LED has many features of high brightness, energy saving, multicolor, and rapid change, and has been widely applied to various lighting fields that require light sources, including the field of automobile lights. Most of LEDs on the market are generally packaged with a single chip, and therefore are spotted light sources when lit. Early LED car lights also feature multi-point light sources to distinguish them with incandescent bulbs.

Japanese patents (JPA patent publication 2012-59736 and JPA patent publication 2016-167518) respectively use a plurality of LED chips arranged in a row and filled with glue to be packaged into a linear LED light bar or a linear LED tube for indoor lighting. Some manufacturers use a plurality of LED chips arranged in a row, and package them into a linear LED water tube light, applied to outdoor decorative lights. The linear LED obtained by packaging the plurality of LED chips has poor reliability in resistance to cold and hot temperature cycles or cold and hot shocks. However, because the linear LED is mostly used in an environment with indoor room temperature or in an outdoor temperature range of -30°C to 50°C, rather than a harsh environment with a large temperature change range, a short-term application does not yet cause any LED failure problem. In contrast, an environment in which the LEDs are applied to automobile exterior lamps is extremely harsh. Therefore, the automobile industry has particularly stringent requirements for LED quality and reliability, such as the AEC-Q102 test specification and the USCAR 33 test specification well known in the industry. The thermal shock test in USCAR 33 requires LEDs to do 1500 cycles of hot and cold shock tests between low and high temperatures, with a test temperature ranging from -55°C to 150°C, far harsher than the foregoing outdoor LED decorative lights use environment. This makes general commercially available LEDs fail to meet the stringent automobile specification requirements. One of the reasons for this is that the adhesive material used for general LED encapsulation is mainly epoxy. Epoxies are thermosetting resins, which become solid after sealing, with relatively high hardness or bulk modulus (of about 1-3 Gpa). A coefficient of linear thermal expansion (CLTE) of epoxy is about 20-40 ppm/°C below a glass transition temperature (Tg), but when the temperature exceeds the glass transition temperature (Tg), the CLTE of epoxy rises rapidly by about 3-4 times, which is much larger than a CLTE of a gold wire (about 14 ppm/°C). When an operating temperature of the LED exceeds the Tg temperature of its colloid, a difference between CLTEs of the colloid and the gold wire becomes larger rapidly, and accordingly, the thermal stress on the gold wire inside the LED rises rapidly, causing the gold wire inside the LED to break due to the thermal stress, resulting in a failure in the LED and its failure to pass the automobile specification test. Therefore, a colloid with a higher Tg temperature is used in general automobile LEDs to make a difference between CLTEs of the colloid and the gold wire is as small as possible, so as to improve the reliability of LED performance at high temperatures.

In addition, in order to develop linear LED car lights with uniform and grain-free bright spots, the patent precedent No. TWI708908, titled: SLIM LINEAR LED LIGHT-EMITTING APPARATUS, proposed a technology of constructing and manufacturing a slim linear LED light-emitting apparatus, which uses package LED bars of a plurality of similar LED chips as light sources. The LED bar is a continuous and visually uniform linear light source, different from the general design of using a granular LED package as a light source, and is especially suitable for high-quality linear car lights. The application of the slim linear LED light-emitting apparatus in linear lamps with slim light guide film designs, especially car lamps, can effectively resolve many problems of the existing LED light sources applied in high-quality car lamps, including visual discontinuity, uneven light and darkness, and granular bright spots that occur in previous LED linear car lamps.

However, when electrodes of LED chips inside a linear LED including a plurality of chips are connected through wire bonding, because CLTEs of a gold wire and a packaging colloid differ a lot, in a temperature change, the colloid generates thermal stress for squeezing or pulling the gold wire, which changes with the drop or rise of the temperature, resulting in thermal fatigue on gold wires and solder joints of the gold wires. Basically, magnitude of the thermal stress is in direct proportion to rigidity or bulk modulus of the colloid and a change range of the temperature. In addition, a longer length of the colloid of the LED indicates greater thermal stress applied by the colloid to gold wires in the LED that are farther from the center of the colloid and solder joints of the gold wires. In other words, in a case that a length of a linear LED is increased due to inclusion of more chips, when the temperature changes significantly, gold wires inside the linear LED suffer from an increased amount of deformation or thermal stress. The magnitude of the thermal stress is closely related to a material and a length of the colloid of the LED, as detailed below. In order to meet the requirements of automobile regulations, silicone is also used in LED encapsulation in recent years. There are mainly two types of silicone for LED encapsulation: methyl (Methyl Base) silicone and phenyl (Phenyl Base) silicone. The methyl silicone has a lower Tg temperature (below -50°C). Therefore, in an environment required by a car (-50°C to 150°C), a bulk modulus of the methyl silicone is maintained at a relatively low value. In other words, the methyl silicone is relatively soft, and thus is generally referred to as soft silicone. For example, a bulk modulus of OE-6351 of Dow-Corning is less than 0.01 Gpa between -50°C and 150°C. When the temperature changes, the thermal stress generated by the methyl silicone on the gold wires in the LED is also lower accordingly. Between -50°C and 150°C, the OE-6351 of Dow-Corning has a CLTE of about 290 ppm/°C, which is 20 times the CLTE of the gold wire. Phenyl silicone is mainly applied to encapsulation of a high-brightness and high power LED due to a relatively high light refractive index (of 1.5-1.6) of the phenyl silicone. However, the Tg temperature of the phenyl silicone is relatively high. For example, Tg of various types of phenyl silicone of Dow-Corning mostly falls between -10°C and 50°C. In other words, the phenyl silicone is usually harder than the methyl silicone at room temperature, and thus is generally referred to as hard silicone. The bulk modulus of the phenyl silicone varies greatly in the use environment (between -50°C and 150°C) required by the car. For example, a bulk modulus of OE-7662 of Dow-Corning is as high as 1 GPa at -50°C, which is 100 times that of methyl silicone OE-6351 of Dow-Corning, decreases rapidly near the Tg point, and is below 3.0 MPa above 50°C. When the temperature changes between 0°C and -50°C, the thermal stress of the phenyl silicone on the gold wires inside the LED is also relatively high. The CLTE of the phenyl silicone also varies significantly with the temperature at the Tg point. For example, a CLTE of OE-7662 of Dow-Corning is about 81 ppm/°C between 0°C and -50°C, which is about one third of that of OE-6351 of the methyl silicone; rises to 181 ppm/°C between 50°C and 150°C, which is close to that of the OE-6351 of the methyl silicone, but is also much greater than that of the gold wire of 14 ppm/°C.

In a range of elastic deformation, the deformation of the material (strain) is linearly related to the stress, that is, Stress = Coefficient of Elasticity (or Coefficient of Stiffness) × strain. Most of the stiffness coefficient for resin-based materials are expressed in terms of a bulk modulus, that is, Pressure = Bulk Modulus × Volume Deformation Ratio. In other words, a higher bulk modulus of an adhesive material used for encapsulation indicates higher stress generated for the same amount of deformation. As can be learned from the foregoing features of the adhesive material commonly used for encapsulation of the LED, the bulk modulus of the epoxy resin is approximately 1 GPa in a range of -50°C to 150°C, thus generating maximum thermal stress on the gold wire. This is the main reason why the LED packaged by the conventional epoxy resin cannot pass the foregoing automobile specifications. The bulk modulus of the phenyl silicone is also approximately 1 GPa in a range from -50°C to the Tg point. Within this low-temperature range, the bulk modulus of the methyl silicone is relatively low, which is only about 0.01 Gpa. Therefore, in the case of small differences in thermal deformation, the thermal stress generated by the phenyl silicone on the gold wire in the LED is also much greater than that generated by the methyl silicone.

Most materials expand with heat and contract with cold, and the colloids and gold wires in the LED are no exception. When the temperature drops, because the CLTE of the colloid is greater than that of the gold wire, the gold wire is deformed due to the squeezing by the contraction of the colloid. On the contrary, when the temperature rises, because the CLTE of the colloid is greater than that of the gold wire, the gold wire is deformed in an opposite direction due to pulling by a great amount of expansion of the colloid. In other words, during the temperature change process, the gold wire in the LED is deformed by the thermal stress in different directions, causing thermal fatigue. When the number of cycles of such temperature changes continues to increase, the gold wire in the LED is broken due to a fatigue damage mechanism. The conventional fatigue service life (that is, the number of times of fatigue caused by fracture) of the gold wire decreases as the fatigue stress increases. In other words, greater thermal stress of thermal fatigue indicates a smaller number of times of thermal fatigue that can be withstood by the gold wire. When a car specification test is performed on the LED, in a same temperature cycle or thermal shock test, greater thermal stress generated by the colloid indicates earlier breakage of the gold wire.

In addition, when the temperature changes, thermal stress on each gold wire varies with different positions in a general linear LED. Because the amount of thermal deformation of the colloid of the LED increases linearly from the center of the colloid to an outer edge of the colloid, a longer distance to the center of the colloid indicates a greater amount of thermal stress and deformation of the gold wire. Therefore, a longer colloid of the LED indicates greater thermal stress on a gold wire close to the outer edge of the colloid.

In an actual case, when an LED of about 5 mm including four chips is packaged by a wire bonding process, and an adhesive material for the encapsulation is phenyl silicone, including LPS-3435 or KER-2460 of Shin-Etsu, or OE-6631 or OE-6636 of Dow-Corning, during the thermal shock test required by the foregoing car specifications USCAR 33, some gold wires in the LED are broken due to the excessive thermal stress of the colloid, and eventually most of LEDs fail in the test. Further analysis found that in the failure mode of all the LEDs that fail in the test, the gold wire closest to the edge of the packaging colloid is broken and the position at which the gold wire is broken is close to a first solder joint, that is, a solder joint close to the upper surface of the LED chip. This confirms that a longer distance from the center of the colloid indicates a larger amount of thermal stress and deformation withstood by the gold wire. The present disclosure focuses on the innovation of an LED colloid structure design, so as to overcome the foregoing problem, and enable a linear LED including a plurality of chips to pass a test meeting the requirements of the car specifications even if the linear LED is packaged by using a wire bonding process and an adhesive material for the encapsulation of the linear LED is a high-hardness adhesive material such as phenyl silicone, so that the linear LED can be applied to exterior lights of automobiles.

### SUMMARY OF THE DISCLOSURE

The technical problem to be resolved by the present disclosure is that, for a linear LED including a plurality of chips, even if a wire bonding process is used for encapsulation and a packaging colloid is a high-hardness adhesive material, for example, a linear LED made of phenyl silicone, an innovative encapsulation structure and a colloidal structure design are provided to reduce thermal stress of a gold wire in the LED and improve its reliability of resistance to cold and hot temperature cycles or cold and hot shocks, so as to meet requirements of thermal shock tests in the automobile USCAR 33 specifications. Another feature of the present disclosure is that this structure can maintain uniformity of linear light emission without causing bright spots or dark areas due to a special structure of the colloid, and cause no difficulties in assembly or the design of light distribution when assembled into a strip light emitting apparatus.

The strip LED of the present disclosure is applicable to the patent precedent No. TWI708908, titled: SLIM LINEAR LED LIGHT-EMITTING APPARATUS, and a slim linear LED light emitting apparatus is provided, to be applied to automobile lights. The strip LED of the present disclosure includes a substrate, a plurality of electrical connection wires (for example: gold wires, aluminum wires, or copper wires), a plurality of LED chips of the same type, and a packaging colloid. A plurality of electric conducting pads are disposed on the substrate, and the plurality of LED chips are arranged linearly at an appropriate interval. A die bonding process is used to fix each LED chip to a corresponding electric conducting pad. According to requirements of the features of the LED chip and electrical connection, a wire bonding process is used to connect one end of a wire to one of the LED chips, and the other end to an electric conducting pad next to the chip. Using an encapsulation process, the packaging colloid is disposed on the substrate, and the packaging colloid covers each LED chip, each electrical connection wire, and each electric conducting pad on the substrate. A special feature is that the packaging colloid has a horizontal trench with a narrow width between two specified adjacent LED chips.

In the strip LED of the present disclosure, the packaging colloid has at least one horizontal trench with a narrow width, so that a length of an equivalent colloid covering an electrical connection wire in the LED is reduced, so as to effectively reduce thermal stress of the colloid on the electric connecting wire (for example, a gold wire), thereby reducing a risk of breakage of the electrical connection wires due to thermal fatigue. A depth of the trench needs to be at least half of a height of the packaging colloid so that the thermal stress of the colloid on an electrical connection wire (for example, a gold wire) can be effectively reduced. In addition, in order to ensure that the packaging colloid effectively covers the LED chip, the electrical connection wire, and the conducting pad of the substrate, a distance between an edge of the trench and each of the LED chip, the electrical connection wire, and the conducting pad of the substrate needs to be at least 0.1 mm.

In order to further understand the features and technical content of the present disclosure, refer to the following detailed description and drawings about the present disclosure. However, the provided drawings are only for reference and description, and are not used to limit the present disclosure.

### BRIEF DESCRIPTION OF THE DRAWINGS

FIG. 1 is a three-dimensional schematic view of a strip LED according to a first embodiment of the present disclosure.
FIG. 2 is a schematic side view of the strip LED according to the first embodiment of the present disclosure.
FIG. 3 is a three-dimensional schematic view of the strip LED according to a second embodiment of the present disclosure.
FIG. 4 is a schematic side view of the strip LED according to the second embodiment of the present disclosure.
FIG. 5 is a three-dimensional schematic view showing that multiple strip LEDs are applied to a strip LED light-emitting apparatus according to the present disclosure.

### DETAILED DESCRIPTION OF THE EXEMPLARY EMBODIMENTS

The following are specific embodiments for illustrating an implementation of a "strip LED and an application apparatus thereof" disclosed in the present disclosure. Those skilled in the art can understand the advantages and effects of the present disclosure from the content disclosed in this specification. The present disclosure can be implemented or applied through other different specific embodiments, and various details in this specification can also be modified and changed based on different viewpoints and applications without departing from the concept of the present disclosure. In addition, as stated in advance, the drawings of the present disclosure are merely simple schematic illustrations, and are not drawn according to actual dimensions. The following embodiments will further describe the related technical content of the present disclosure in detail, but the disclosed content is not intended to limit the protection scope of the present disclosure.

It should be understood that although terms such as "first", "second", and "third" may be used herein to describe various components, these components should not be limited by these terms. These terms are mainly used to distinguish one component from another. In addition, the term "or" used herein may include any one or a combination of associated listed items, depending on an actual situation.

### [Embodiments]

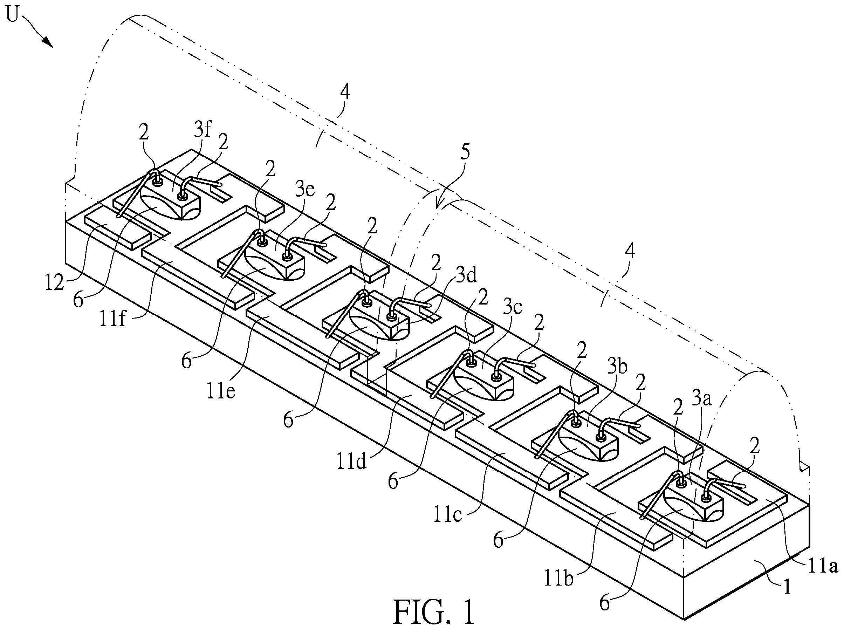

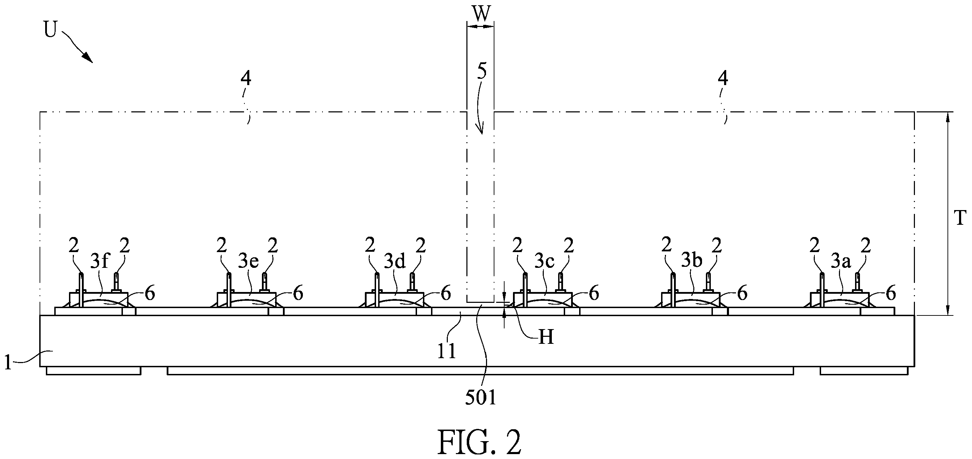

Referring to FIG. 1 and FIG. 2, FIG. 1 is a three-dimensional schematic view of a strip LED (U) according to an embodiment of the present disclosure, and FIG. 2 is a schematic side view of the strip LED (U) according to the embodiment of the present disclosure. In FIG. 1, the strip LED (U) includes a substrate (1), twelve electrical connection wires (2), six LED chips (3a, 3b, 3c, 3d, 3e, 3f), and a packaging colloid (4). The packaging colloid (4) has a horizontal trench (5), that is, a direction of the horizontal trench is perpendicular to an arrangement direction of the six LED chips (3a, 3b, 3c, 3d, 3e, 3f). The six LED chips (3a, 3b, 3c, 3d, 3e, 3f) are all horizontal LED chips, and a positive electrode (P) and a negative electrode (N) of each LED chip are both on an upper surface of the LED chip. Therefore, each LED chip needs two separate electrical connection wires (2) for electrical connection. The substrate (1) includes six electric conducting pads (11, including 11a, 11b, 11c, 11d, 11e, 11f) corresponding to the six LED chips (3a, 3b, 3c, 3d, 3e, 3f) and one electric conducting pad (12) with no LED chip. An area of the electric conducting pad (12) is smaller than that of the electric conducting pad (11) because there is no need to provide any LED chip. The six LED chips (3a, 3b, 3c, 3d, 3e, 3f) are linearly arranged at equal intervals. A die bonding process is used, so that each LED chip is fixed to a corresponding electric conducting pad (11) by using a solid crystal adhesive (6). A wire bonding process is used, so that each electrical connection wire (2) has one end connected to one of the LED chips and the other end connected to an electric conducting pad (11) or an electric conducting pad (12) adjacent thereto. The electrical connection wire (2) of this embodiment is a gold wire with a wire diameter of 1.2 mil. An encapsulation process is used, so that the packaging colloid (4) is disposed on the substrate 1 and covers each LED chip, each electrical connection wire (2), and each electric conducting pad (11, 12) on the substrate (1). As shown in FIG. 2, the packaging colloid (4) in this embodiment covers only an upper surface of the substrate (1), with a colloid height (T) of about 1.7 mm. One feature of the present disclosure is that the packaging colloid (4) has the horizontal trench (5) between two specified adjacent LED chips. In this embodiment, the horizontal trench (5) in the packaging colloid (4) is formed between the third LED chip (3c) and the fourth LED chip (3d), and the direction of the horizontal trench (5) is perpendicular to the arrangement direction the six LED chips.

In this embodiment, the horizontal trench (5) is formed on an encapsulation preform (not shown in the figures) of the LED by cutting the encapsulation preform with a diamond cutting blade. Therefore, in FIG. 2, a width (W) of the horizontal trench (5) is determined by a thickness of the selected diamond cutting blade. Basically, the width (W) of the horizontal trench (5) should not be extremely large, so as not to affect a light shape of the LED or cause visual unevenness. Therefore, the width (W) of the horizontal trench (5) of the present disclosure is preferably 0.1-0.3 mm, subject to a limit of the thickness of the diamond cutting blade. In FIG. 2, a depth of the horizontal trench (5) is determined by a height (H) of the bottom of the horizontal trench. The height (H) of the bottom the trench refers a vertical distance between the bottom (501) of the horizontal trench and a surface of an upper electric conducting pad layer of the substrate (1). In order to effectively reduce the thermal stress of the colloid on an electrical connection wire (for example, a gold wire), a depth of the trench cut by a diamond cutter needs to be at least half of the height (T) (1.7 mm) of the packaging colloid so that the height (H) of the bottom of the trench is between 0.1 mm and one half of the height of the packaging colloid (that is, 0.8 mm), thereby ensuring that the packaging colloid effectively covers the conducting pad of the substrate. The height (H) of the bottom of the trench in this embodiment is controlled between 0.1 mm and a height of the upper surface of the LED chip (3c, 3d), so as to more effectively reduce the thermal stress of the colloid on the electrical connection wire (for example, the gold wire). A height of the LED chip (3c, 3d) in this embodiment is 0.3 mm. Therefore, a preferred embodiment of the present disclosure is to control the height (H) of the bottom of the horizontal trench to be between 0.1 mm and 0.3 mm, so that the colloid can still completely cover each LED chip and each electric conducting pad on the substrate and the thermal stress of the colloid on the electrical connection wires can be more effectively reduced.

As for how to select two specified adjacent LED chips to be provided with the horizontal trench (5), or how many horizontal trenches (5) are to be provided, it depends on a total length of the packaging colloid, a material of the packaging colloid, tensile strength of the electrical connection wire (2), and a temperature range of a thermal cycle (or thermal shock). In general, a larger quantity of horizontal trenches in the colloid of the LED indicates less thermal stress withstood by the electrical connection wires in the LED and higher reliability of resistance to cold and hot temperature cycles or cold and hot shocks. In contrast, when a larger quantity of horizontal trenches are provided in the colloid of the LED, manufacturing difficulty or cost is higher accordingly.

The efficacy of the present disclosure is described as follows. In this embodiment, the horizontal trench with the depth close to a surface of the LED is provided in the middle of the packaging colloid of the strip LED, and the effect is the same as that of dividing the original colloid into two half-length packaging colloids, that is, forming two separate new colloid centers. This is equivalent to halving a distance from the gold wire at the rightmost edge of the LED to a center of a covered colloid on the right. When an effective length of thermal stress generated by the covered colloid on the gold wire becomes shorter, the thermal stress of the colloid on the gold wire is relatively reduced, thereby reducing a risk of breakage of the gold wire due to thermal fatigue, and improving a service life and reliability of the LED to withstand hot and cold cycles or hot and cold shocks. In view of the above, the present disclosure is not limited to a material and type of the substrate (1). For example, the substrate (1) is a two-layer substrate with conductive layers on the top and bottom (front and back), which may be a bismaleimide triazine (BT) board, a ceramic substrate, or a composite substrate with separate metal blocks embedded in resin. Alternatively, the substrate (1) may be a BT board or a ceramic substrate with at least two conductive layers, so as to increase flexibility of circuit routing design. In addition, the present disclosure is not limited by shapes of the electric conducting pads (11) and (12).

The present disclosure is applicable to LED chips of different implementations, including a vertical LED chip (referring to case that the positive electrode (P) and the negative electrode (N) of the LED chip are separate on different sides of the LED chip, that is, one is on the front surface and the other on the bottom surface), a horizontal LED chip (referring to a case that both the positive electrode (P) and the negative electrode (N) of the LED chip are on the front surface or the upper surface of the LED chip), and the like. Both the vertical LED chip and the horizontal LED chip need to be packaged through die bonding and wire bonding processes, resulting in the foregoing problem of breakage of the gold wire due to the thermal fatigue.

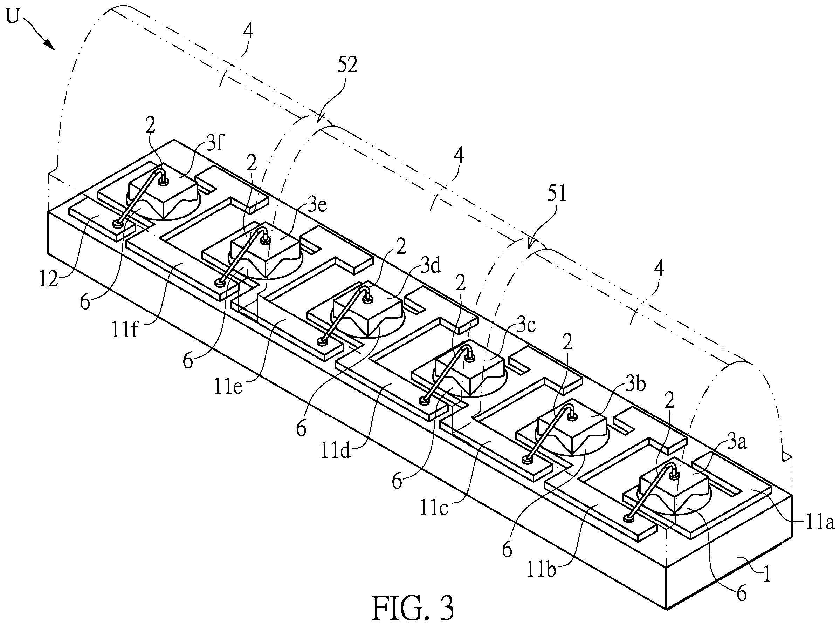

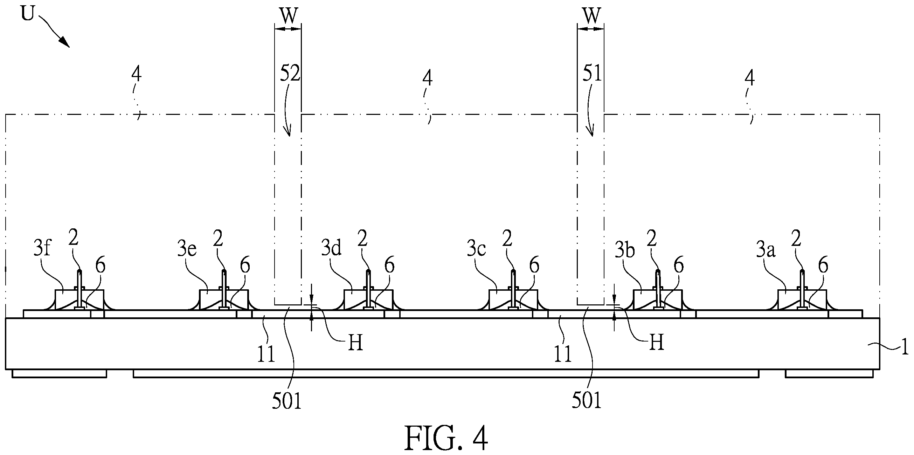

FIG. 3 and FIG. 4 show a second embodiment of the present disclosure. An LED chip shown in the figures is a vertical LED chip. The vertical LED chip has an electrode (for example, a positive electrode (P)) located on an upper surface of the chip and the other electrode (for example, a negative electrode (N)) located on a lower surface of the chip. In this embodiment, the LED chip (3a, 3b, 3c, 3d, 3e, 3f) is first fixed to a corresponding electric conducting pad (11, including 11a, 11b, 11c, 11d, 11e, 11f) with a conductive solid crystal adhesive (6) (for example, colloidal silver), and then the electrode (P) on the upper surface of each LED chip and another electric conducting pad (11) or an electric conducting pad (12) adjacent thereto are connected through an electrical connection wire (2) through a wire bonding process. In this embodiment, the LED chip (3a) is fixed to the corresponding electric conducting pad (11a), and the electrical connection wire (2) connecting the electrode (P) on the upper surface of the LED chip (3a) is formed in the electric conducting pad (11b) through wire bonding, and so on, except that the electrical connection wire (2) connecting the electrode (P) on the surface of the LED chip (3f) is formed in the electric conducting pad (12) through wire bonding.

In this embodiment, the packaging colloid (4) includes two horizontal trenches (51, 52), where the first horizontal trench (51) is formed between the second LED chip (3b) and the third LED chip (3c), the second horizontal trench (52) is formed between the fourth LED chip (3d) and the fifth LED chip (3e), and a direction of the horizontal trench (51, 52) is perpendicular to an arrangement direction of the six LED chips (3a, 3b, 3c, 3d, 3e, 3f). As described above, a quantity of horizontal trenches in the colloid of the LED in this embodiment is increased. Therefore, reliability of resistance to cold and hot temperature cycles or cold and hot shocks is also increased accordingly.

The packaging colloid of the strip LED of the present disclosure has at least one horizontal trench with a narrow width, leading to a reduced effective length of the thermal stress generated by the colloid on the electrical connection wire, including effectively reducing the thermal stress of the colloid on the conducting wire, thereby reducing a risk of breakage of the conducting wire due to thermal fatigue.

It should be further noted that, the present disclosure does not limit a gold wire direction of the electrical connection wire of the LED, but gold wire directions of the electrical connection wires on both sides of each colloid a horizontal trench need to be parallel to the direction of the horizontal trench as much as possible, to avoid impact on the formation of the horizontal trench in the colloid or a case that the colloid cannot cover each electrical connection wire.

In addition, it should be noted that, the present disclosure is not limited by a quantity of LED chips. The present disclosure is not limited by a quantity of horizontal trenches in the colloid of the LED. The formation of the horizontal trench in the colloid of the LED of the present disclosure is not limited to the formation by cutting an encapsulation preform with a diamond cutting blade, and may alternatively use a molding process, such as direct molding and transfer molding or injection molding processes, for colloid covering, and the horizontal trench is formed in the colloid at the same time. However, when the horizontal trench in the colloid is formed by using the molding process, limited to a demolding condition, the horizontal trench in the colloid needs to have a draft angle, the width of the horizontal trench needs to be relatively wide, that is, a spacing between the LED chips needs to be relatively large, and the quantity of horizontal trenches that can be formed in the colloid is relatively small.

In a functional test of an actual sample of the present disclosure, resin selected for the packaging colloid of the LED is a type of phenyl silicone made by Dow Corning. A thermal shock test in USCAR 33 of the Car Grade LED is performed on two different LEDs with the same length and the same LED chips disposed inside, where one is an LED having a colloid with a horizontal trench and the other is an LED having a colloid without a horizontal trench. A test condition is a cold and hot shock between a low temperature of -55°C and a high temperature of 150°C. A test time is 1512 hours (equivalent to 3000 cycles). A test result shows that after the test time reaches 1344 hours, a sample failure rate of the LED having the colloid without a horizontal trench is 80/80, that is, all 80 test samples fail. However, after the test time reaches 1512 hours, a sample failure rate of the LED having the colloid with a horizontal trench is 0/80, that is, none of the samples fail. The test result fully confirms the specific efficacy and progressiveness of the present disclosure.

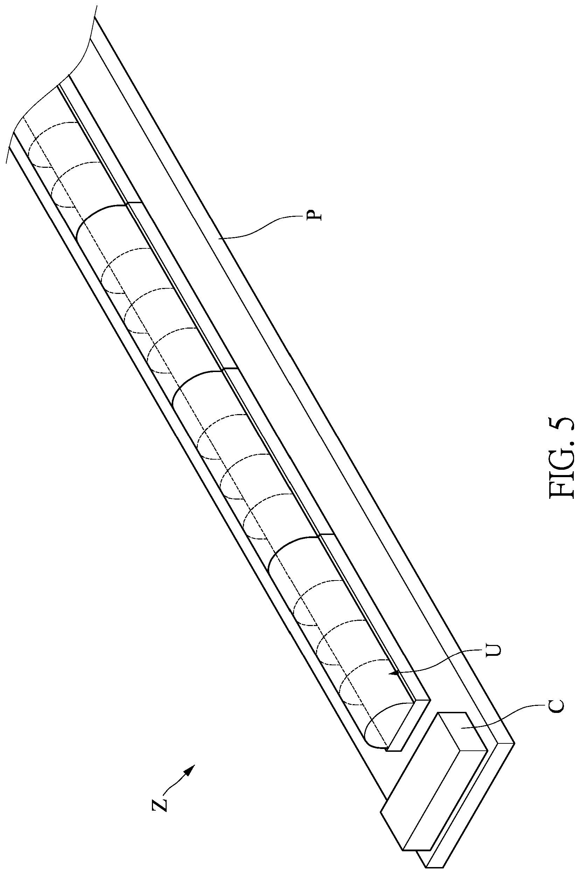

FIG. 5 is a three-dimensional schematic view showing that the strip LED is applied to a strip LED light-emitting apparatus (Z) according to the present disclosure. In this embodiment, the strip LED light-emitting apparatus (Z) includes a printed circuit board (PCB) (P), a plurality of strip LEDs (U) of the present disclosure, and at least one electrical connector (C). The strip LED (U) and the electrical connector (C) are disposed on the PCB (P) by using an SMT process, to form the strip LED light-emitting apparatus (Z). The present disclosure is not limited by a quantity of strip LEDs (U).

The contents disclosed above are merely the preferred and feasible embodiments of the present disclosure, and do not limit the scope of the patent application of the present disclosure. Therefore, all equivalent technical changes made by using the contents of this specification and the drawings of the present disclosure are included in the scope of the patent application of the present disclosure.

The foregoing description of the exemplary embodiments of the disclosure has been presented only for the purposes of illustration and description and is not intended to be exhaustive or to limit the disclosure to the precise forms disclosed. Many modifications and variations are possible in light of the above teaching.

The embodiments were chosen and described in order to explain the principles of the disclosure and their practical application so as to enable others skilled in the art to utilize the disclosure and various embodiments and with various modifications as are suited to the particular use contemplated. Alternative embodiments will become apparent to those skilled in the art to which the present disclosure pertains without departing from its spirit and scope.

## Claims

1. A strip light-emitting diode (LED) (U), comprising:
a substrate (1), including a plurality of electric conducting pads (11, 11a, 11b, 11c, 11d, 11e, 11f);
a plurality of LED chips (3a, 3b, 3c, 3d, 3e, 3f), the plurality of LED chips (3a, 3b, 3c, 3d, 3e, 3f) being linearly arranged, and each LED chip (3a, 3b, 3c, 3d, 3e, 3f) being disposed on a corresponding electric conducting pad (11, 11a, 11b, 11c, 11d, 11e, 11f) on the substrate (1);
a plurality of electrical connection wires (2), each electrical connection wire (2) having one end connected to one of the LED chips (3a, 3b, 3c, 3d, 3e, 3f) and the other end connected to an adjacent electric conducting pad (11, 11a, 11b, 11c, 11d, 11e, 11f); and
a packaging colloid (4), disposed on the substrate (1), the packaging colloid (4) covering each LED chip (3a, 3b, 3c, 3d, 3e, 3f), each electrical connection wire (2), and each electric conducting pad (11, 11a, 11b, 11c, 11d, 11e, 11f) on the substrate (1), the packaging colloid (4) having a horizontal trench (5) between two adjacent LED chips (3a, 3b, 3c, 3d, 3e, 3f), a direction of the horizontal trench (5) being substantially perpendicular to an arrangement direction of the plurality of LED chips (3a, 3b, 3c, 3d, 3e, 3f), a height (H) of the bottom of the horizontal trench (5) being between 0.1 mm and one half of a height of the packaging colloid (4).

2. The strip LED (U) according to claim 1, wherein the horizontal trench (5) is formed by cutting the packaging colloid (4) after the LED chip (3a, 3b, 3c, 3d, 3e, 3f) has undergone an encapsulation process, and a width of the horizontal trench (5) is in a range of 0.1 mm to 0.3 mm.

3. The strip LED (U) according to claim 1, wherein the height (H) of the bottom of the horizontal trench (5) is between 0.1 mm and 0.3 mm.

4. The strip LED (U) according to claim 1, wherein the horizontal trench (5) is formed by molding in an encapsulation process of the LED chip (3a, 3b, 3c, 3d, 3e, 3f).

5. A strip light-emitting diode (LED) (U), comprising:
a substrate (1), including a plurality of electric conducting pads (11, 11a, 11b, 11c, 11d, 11e, 11f);
six vertical LED chips (3a, 3b, 3c, 3d, 3e, 3f), the six LED chips (3a, 3b, 3c, 3d, 3e, 3f) being linearly arranged at equal intervals, and each LED chip (3a, 3b, 3c, 3d, 3e, 3f) being disposed on a corresponding electric conducting pad (11, 11a, 11b, 11c, 11d, 11e, 11f);
six electrical connection wires (2), each electrical connection wire (2) having one end connected to one of the LED chips (3a, 3b, 3c, 3d, 3e, 3f) and another other end connected to an adjacent electric conducting pad (11, 11a, 11b, 11c, 11d, 11e, 11f); and
a packaging colloid (4), disposed on the substrate (1), the packaging colloid (4) covering each LED chip (3a, 3b, 3c, 3d, 3e, 3f), each electrical connection wire (2), and each electric conducting pad (11, 11a, 11b, 11c, 11d, 11e, 11f) on the substrate (1), wherein
the packaging colloid (4) has a first horizontal trench (51) between a second LED chip (3a, 3b, 3c, 3d, 3e, 3f) and a third LED chip (3a, 3b, 3c, 3d, 3e, 3f), a direction of the first horizontal trench (51) is perpendicular to an arrangement direction of the six LED chips (3a, 3b, 3c, 3d, 3e, 3f), the packaging colloid (4) has a second horizontal trench (52) between a fourth LED chip (3a, 3b, 3c, 3d, 3e, 3f) and a fifth LED chip (3a, 3b, 3c, 3d, 3e, 3f), a direction of the second horizontal trench (52) is perpendicular to the arrangement direction of the six LED chips (3a, 3b, 3c, 3d, 3e, 3f), and a height (H) of a bottom of each of the first horizontal trench (51) and the second horizontal trench (52) is between 0.1 mm and one half of a height of the packaging colloid (4).

6. A strip light-emitting diode (LED) light-emitting apparatus (Z), comprising:
a printed circuit board (PCB) (P), including at least one electrical connector (C) and a plurality of strip LEDs (U), each strip LED (U) including:
a substrate (1), including a plurality of electric conducting pads (11, 11a, 11b, 11c, 11d, 11e, 11f);
a plurality of LED chips (3a, 3b, 3c, 3d, 3e, 3f), the plurality of LED chips (3a, 3b, 3c, 3d, 3e, 3f) being linearly arranged, and each LED chip (3a, 3b, 3c, 3d, 3e, 3f) being disposed on a corresponding electric conducting pad (11, 11a, 11b, 11c, 11d, 11e, 11f);
a plurality of electrical connection wires (2), each electrical connection wire (2) having one end connected to one of the LED chips (3a, 3b, 3c, 3d, 3e, 3f) and another end connected to an adjacent electric conducting pad (11, 11a, 11b, 11c, 11d, 11e, 11f); and
a packaging colloid (4), disposed on the substrate (1), the packaging colloid (4) covering each LED chip (3a, 3b, 3c, 3d, 3e, 3f), each electrical connection wire (2), and each electric conducting pad (11, 11a, 11b, 11c, 11d, 11e, 11f) on the substrate (1), the packaging colloid (4) having a horizontal trench (5) between two adjacent LED chips (3a, 3b, 3c, 3d, 3e, 3f), a direction of the horizontal trench (5) being substantially perpendicular to an arrangement direction of the plurality of LED chips (3a, 3b, 3c, 3d, 3e, 3f), and a height (H) of the bottom of the horizontal trench (5) being between 0.1 mm and one half of a height of the packaging colloid (4).
